# EUROPEAN PATENT APPLICATION

(11) **EP 2 139 304 A1**
(43) Date of publication of application: **30.12.2009**
(21) Application number: 09152045.2
(22) Date of filing: 04.02.2009
(51) Int. Cl.: H05K 1/02

(54) **Printed substrate and electronic device**

(30) Priority: 27.06.2008 JP 2008168499
(71) Applicant: Fujitsu Limited, Kawasaki-shi, Kanagawa 211-8588 (JP)
(72) Inventor: Mizuno, Yusuke, Kawasaki-shi, Kanagawa 211-8588 (JP)
(74) Representative: Stebbing, Timothy Charles

(57) **Abstract**

A printed substrate (30) includes: a plurality of pads (32) provided in a mounting area (30R), and having a polygonal shape, in which an electronic component (50) is mounted; and a hole (35) facing and extending along at least two adjacent sides of the polygonal shape.

## Description

The present invention is related to a printed substrate that is provided with a plural pads and an electronic device with the printed substrate.

Conventionally, there has been known an electronic device with a printed substrate installed therein. In such a printed substrate, there have been known techniques for ensuring an electronic connection of an electronic component with the printed substrate via solder bumps (see Japanese Laid-open Patent Publication No. 11-40901).

However, when a stress is applied to the printed substrate from any cause, the solder bump may be peeled off from the printed substrate, resulting in an electrical connection failure.

Embodiments of the invention may provide a printed substrate and an electronic device, thereby preventing an electrical connection failure.

According to an aspect of the invention, a printed substrate includes: a plurality of pads provided in a mounting area, and having a polygonal shape, in which an electronic component is mounted; and a hole facing and extending along at least two adjacent sides of the polygonal shape.

Therefore, in a case where the electronic component is mounted on the printed substrate via the solder bump, the concentration of the load on the solder bump, which is arranged at a corner portion defined by two adjacent sides of the polygonal shape, is prevented. Therefore, the peeling of the solder bump and the printed substrate is prevented, and the electronic connection failure of the electronic component and the printed substrate can be prevented.

It is to be understood that both the foregoing general description and the following detailed description are exemplary and explanatory and are not restrictive of the embodiment, as claimed.

Reference is made, by way of example only, to the accompanying drawings in which:
FIGs. 1A to 1C illustrate a notebook computer;
FIG. 2 illustrates a printed substrate provided in the notebook computer;
FIG. 3 illustrates the printed substrate provided in the notebook computer;
FIGs. 4A and 4B are explanatory views of a package;
FIG. 5 is an enlarged view of a mounting area;
FIG. 6 is an enlarged view of a corner portion of the package;
FIG. 7 is a comparative view of a maximum value of von Mises stress;
FIG. 8 illustrates a first variation of a printed substrate; and
FIG. 9A illustrates a printed substrate according to a second variation, FIG. 9B illustrates a printed substrate according to a third variation, and FIG. 9C illustrates a printed substrate according to a fourth variation.

A description will be given of an embodiment below.

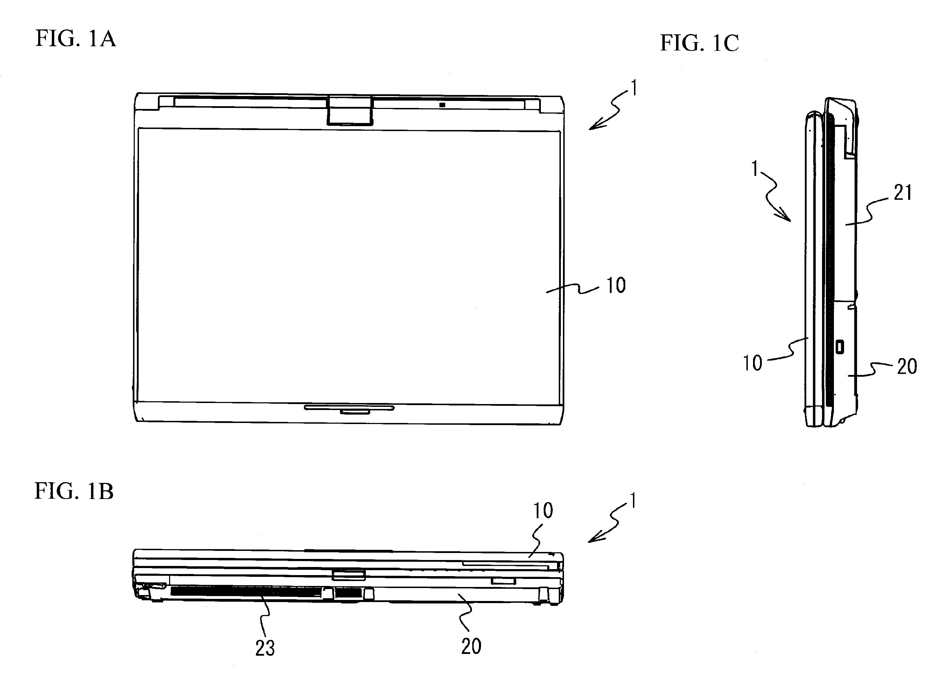

FIGs. 1A to 1C illustrate a notebook-size personal computer 1 (hereinafter referred to as a notebook computer) corresponding to a portable electronic device. FIG. 1A is a front view of the notebook computer 1, and FIG. 1B is a side view of the notebook computer 1, and FIG. 1C is a bottom view of the notebook computer 1.

The notebook computer 1 includes a display portion 10 and a main portion 20. The display portion 10 is coupled to the main portion 20 by hinge (not illustrated) so as to be openable and closable. FIGs. 1A to 1C illustrate the notebook computer 1 in which the display portion 10 is closed. A display (not illustrated) is provided on a surface, facing the main portion 20, of the display portion 10. A keyboard (not illustrated) is provided on a surface, facing the display portion 10, of the main portion 20. Further, a tray 21 for inserting and removing a CD (Compact Disk), a DVD (Digital Versatile Disk) , and the like, is provided on the right side of the main portion 20. Additionally, in a front portion of the main portion 20, air holes 23 are provided for cooling the inside of the main portion 20. The housing of the main portion 20 of the notebook computer 1 houses a printed substrate 30 mentioned below.

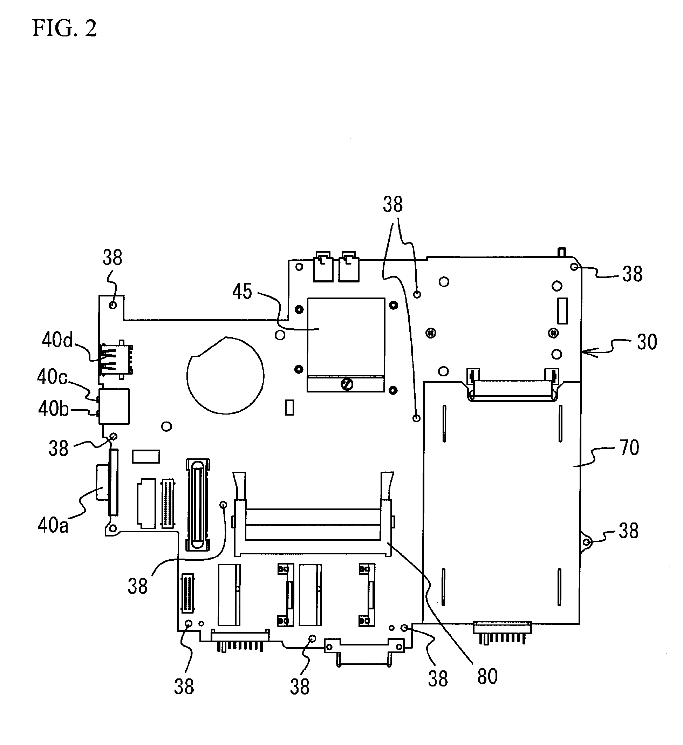

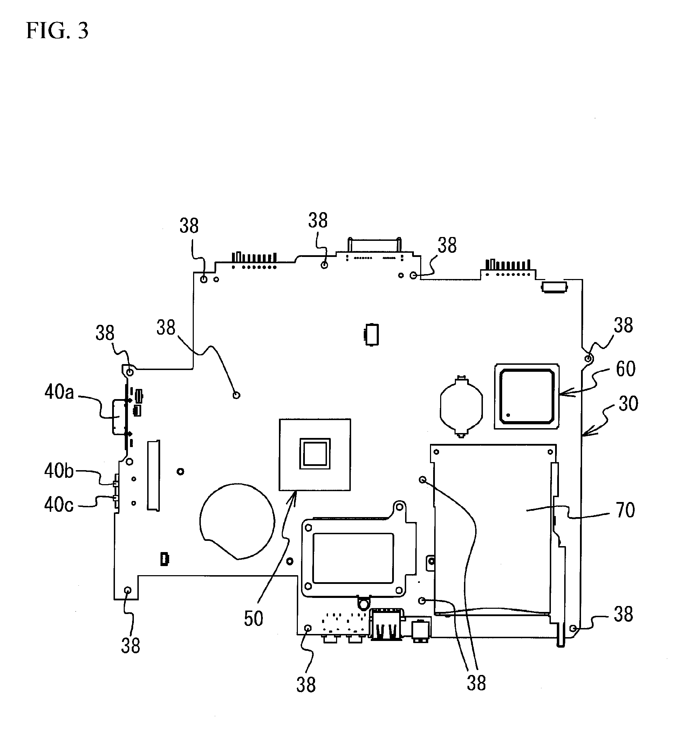

FIGs. 2 and 3 illustrate the printed substrate 30 provided in the notebook computer 1. FIG. 2 illustrates a front surface of the printed substrate 30. FIG. 3 illustrates a rear surface of the printed substrate 30. The printed substrate 30 is a motherboard of the notebook computer 1. An external monitor connector 40a, a headphone connector 40b, and a microphone connector 40c are mounted on the front surface of the printed substrate 30. Further, a USB (Universal Serial Bus) connector 40d, a CPU (Central Processing Unit) 45, a memory slot 80 and the like are mounted on the front surface of the printed substrate 30. Plural holes 38 are formed in the printed substrate 30. A semiconductor package (hereinafter, referred to as a package) 50 having the BGA (Ball Grid Array) structure, an IHC (I/O Controller Hub) 60 are provided on the rear surface of the printed substrate 30. Additionally, a hard disk 70 is mounted on both surface of the printed substrate 30.

The CPU 45 controls the entire operation of the notebook computer 1. The hard disk 70 stores various programs, data, and the like. The memory slot 80 is provided for mounting a memory module such as a RAM (Random Access Memory) on the printed substrate 30.

The holes 38 are provided for fixing the printed substrate 30 within the housing of the main portion 20 by screws. Thus, the printed substrate 30 is secured in the main portion 20. The package 50 has a square shape, and may have a rectangular shape. The square shape and the rectangular shape correspond to the polygonal shape.

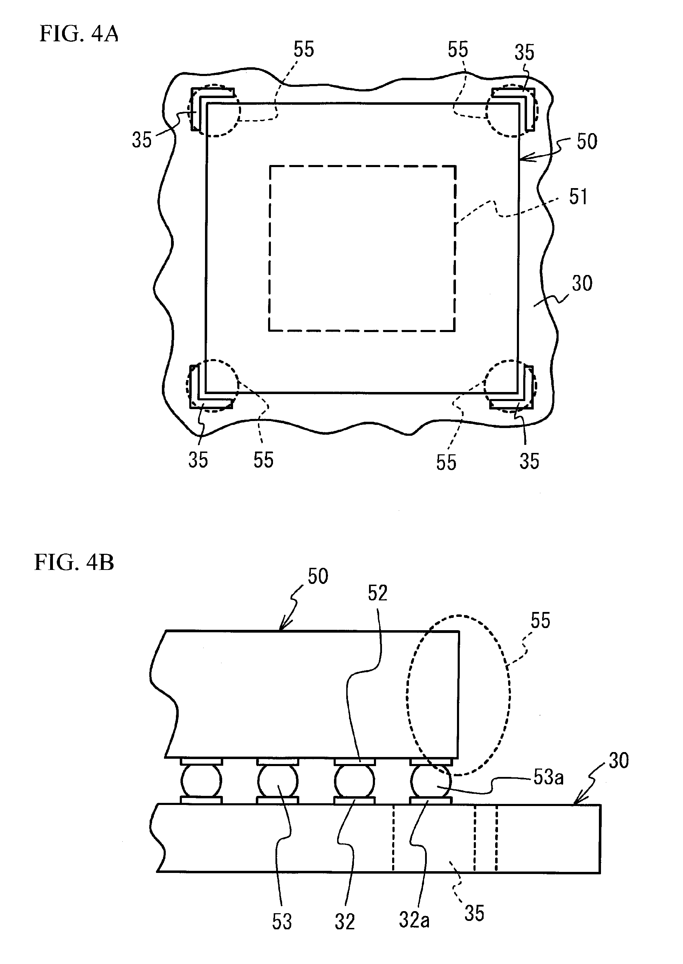

Next, a description will be given of the package 50 in more detail. FIGs. 4A and 4B are explanatory views of the package 50. FIG. 4A is an enlarged view of the package 50 mounted on the printed substrate 30. FIG. 4B is a side view of the package 50. The package 50 corresponds to an electrical component.

A semiconductor chip 51 is built in the package 50. Additionally, plural pads 52 are provided on a bottom surface of the package 50 in a grid pattern. Solder bump (hereinafter referred to as a bump) 53 is bonded to the pad 52. Plural pads 32 bonded to the bumps 53 are provided on the printed substrate 30. The semiconductor chip 51 is electrically connected with the pad 52 via wires (not illustrates). A wiring pattern electrically connecting with the pads 32 are provided on the printed substrate 30. As mentioned above, the electrical connection of the package 50 and the printed substrate 30 is ensured.

As illustrated in FIGs. 4A and 4B, four holes 35 which respectively face four corner portions 55 of the package 50 are provided on the printed substrate 30. The hole 35 has an oblong hole shape along the shape of the corner portion 55 of the package 50, and has a substantially L shape along two adjacent sides of an outer periphery of the package 50. The hole 35 penetrates though the printed substrate 30. The holes 35 are formed by routing.

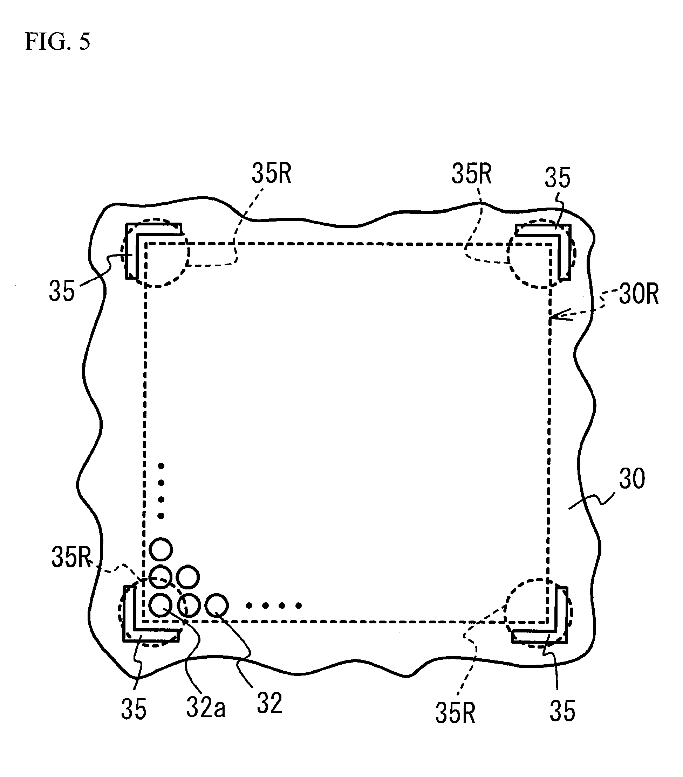

FIG. 5 is an enlarged view of a mounting area 30R of the package 50 before the package 50 is mounted. The mounting area 30R has a square shape. The square shape corresponds to the polygonal shape. The plural pads 32 are provided in the mounting area 30R. Additionally, the holes 35 respectively face the four 35R of the mounting area 30R. The hole 35 faces pad 32a, which is one of the plural pads 32 provided in the mounting area 30R and which is arranged closest to a corner of the mounting area 30R. Also, some of the pads 32 are omitted in FIG. 5. Moreover, each pad may have a circular shape and a rectangular shape.

The four holes 35 are provided to be each extending along two adjacent sides of the mounting area 30R. In other words, the four holes 35 includes a first hole extending along a first side and a second side of the polygonal shape of the mounting area 30R; and a second hole extending along a third side and a fourth side of the polygonal shape of the mounting area 30R. Further, the four holes 35 includes a third hole extending along the first side and the fourth side of the polygonal shape; and a fourth hole extending along the second side and the third side of the polygonal shape. Herein, the first side and the third side of the polygonal shape oppose to each other, and the second side and the fourth side of the polygonal shape oppose to each other. Furthermore, these four holes 35 are apart from one another.

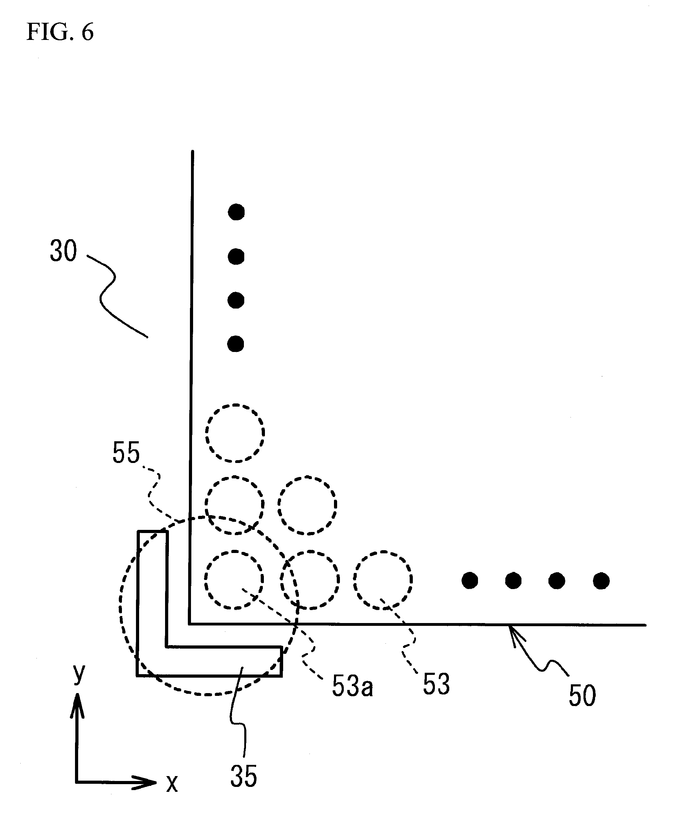

FIG. 6 is an enlarged view of the corner portion 55. The hole 35 is formed to surround the bump 53a, which is arranged closest to a corner of the package 50 and which is one of the bumps 53. Additionally, some of the bumps 53 are omitted in FIG. 6.

In this manner, when a deformation such as a bending is caused in the printed substrate 30, the hole 35 formed to faces the corner portion 55 will absorb the deformation. This reduces the load applied to the corner portion 55 of the package 50, namely, to the bump 53a.

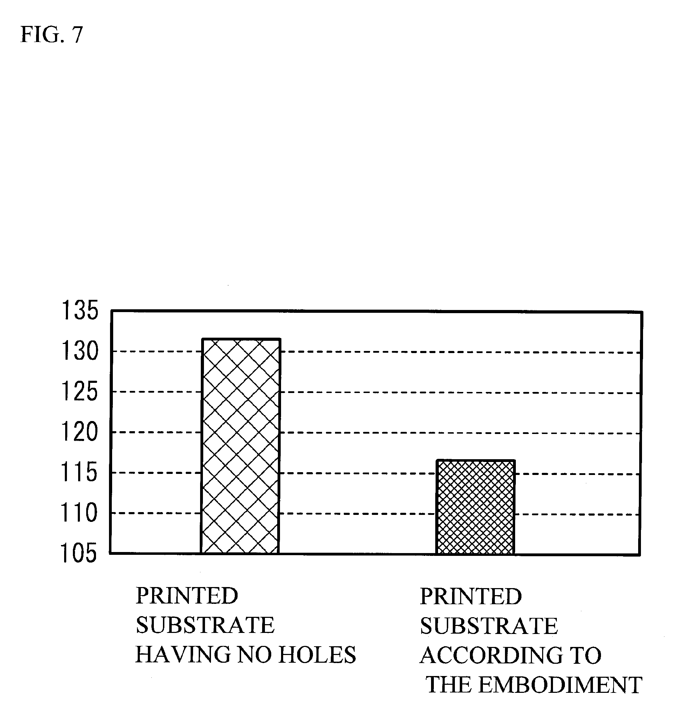

FIG. 7 is a comparative view of a maximum value of von Mises stress of a printed substrate that is provided with no holes such as holes 35 and the printed substrate 30 according to the present embodiment. In FIG. 7, the maximum value of von Mises stress in a corner portion of the package 50, namely, in a position corresponding to the bump 53a is calculated by a simulation. The maximum value of von Mises stress of the printed substrate that dose not provided with the hole 35 is 132.1 MPa. On the other hand, the maximum value of von Mises stress of the printed substrate according to the present embodiment is 116.3 MPa. In this manner, the hole 35 can reduce the load applied to the corner portion 55, namely, to the bump 53a.

A description will be given of the reason why the hole 35 is arranged to face the corner portion 55. For example, if the notebook computer 1 is dropped, the printed substrate 30 is deformed by the impact. The bump 53 may be peeled off from the printed substrate 30 by the deformation of the printed substrate 30. Specifically, the bump 53a, which is one of the bumps 53 and which is arranged closest to a corner, will be peeled off with ease. The reason will be described below. Regarding the bumps 53 other than the bump 53a arranged closest to a corner, the joint of the package 50 and the printed substrate 30 is maintained by the adjacent bumps 53. However, regarding the bump 53a arranged closest to a corner, since the numbers of the bumps 53 adjacent to the bump 53a is smaller, the bump 53a is considered to be peeled off with ease.

Therefore, the hole 35 is provided to face the corner portion 55, thereby reducing the load applied to the bump 53a. This prevents the bump 53a from being peeled off from the printed substrate 30. Therefore, an electrical connection of the printed substrate 30 and the package 50 is ensured, and the failure of the notebook computer 1 is prevented.

Additionally, since an electrical component generating heat is mounted on the printed substrate 30, the heat may be transmitted to the printed substrate 30, so that the printed substrate 30 may be thermally expanded in some cases. Specifically, the CPU 45 and the hard disk 70 generate heat and the circumference thereof becomes high temperatures, so that the heat distribution of the printed substrate 30 becomes uneven. Additionally, the CPU 45 is mounted on the front surface of the printed substrate 30, so that a temperature difference occurs between the front and rear surfaces of the printed substrate 30. The printed substrate 30 may be deformed such as bended by such uneven heat distribution. The load which is applied to the bump 53a and which is caused by the thermal influence may be reduced.

Additionally, in a case where lead-free solder is used for the bumps 53 in light of environmental issues, the joint force may be reduced to peel the bump 53a. However, be employing the printed substrate according to the present embodiment, even when the lead-free solder is used, the bump 53a is peeled off.

As illustrated in FIG. 6, preferably, each of the length of the hole 35 in the y direction and in the x direction are larger than diameters of the bump 53a and the pad 32a. This reduces the concentration of the load applied to the bump 53a.

For example, the length of the hole 35 may be formed to reach the middle in the each side of the package 50. However, the hole 35 is made too long, the wiring pattern ensuring the electrical connection of the bumps 53 will be interrupted. In addition, the mounting area of the other electrical component will be smaller.
Therefore, the length and the size of the hole 35 are preferably set to face the corner portion 55 in light of the wiring pattern, the mounting area, and the prevention of the peel off of the bumps 53.

Additionally, to prevent the bump 53a from being peeled off, an adhesion bond is applied around the bump 53a to strengthen the joint bonding. However, the application of the adhesion bond causes the weight of the printed substrate 30 to be increased by the adhesion bond. Additionally, since the application of the adhesion bond is performed after the package 50 is mounted on the printed substrate 30, the work becomes complicated. In the present embodiment, however, the holes 35 are provided in the printed substrate 30, thereby reducing the printed substrate 30 in weight. The outer shape of the printed substrate 30 and the hole 35 are integrally formed by the routing, thereby improving the efficiency in the workability. The improved efficiency in the workability can reduce the manufacturing cost.

Additionally, the shape of the hole 35 is a substantially L shape and is not limited to this shape. For example, the shape of the hole 35 may be a substantially C shape.

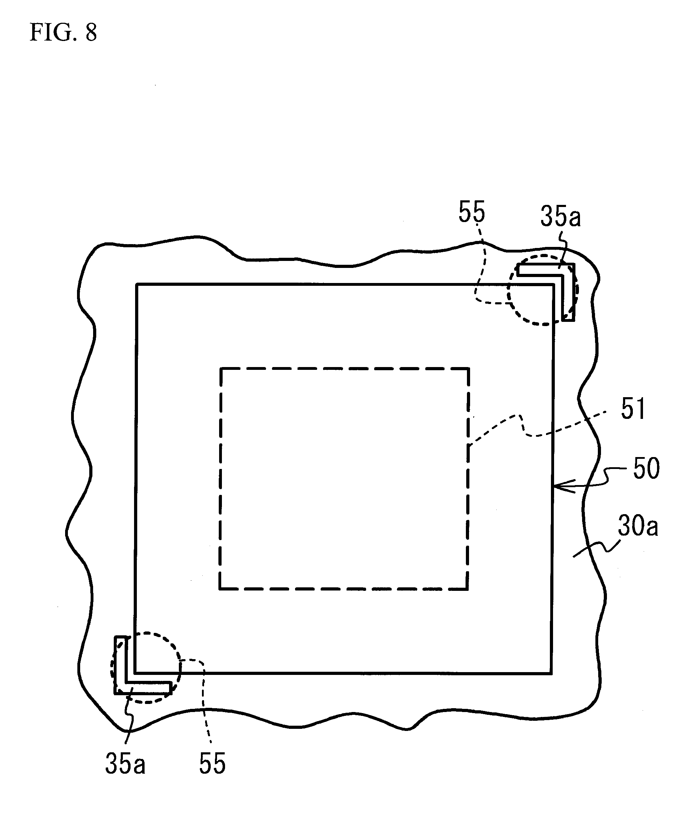

Next, a description will be given of variations of the printed substrate. Additionally, in the variations discussed below, like numerals depict like members or components according to the above embodiment to avoid duplication of explanation. FIG. 8 illustrates a first modification of a printed substrate 30a. FIG. 8 corresponds to FIG. 4A. As illustrated in FIG. 8, two holes 35a are provided to face two corner portions 55 arranged on a diagonal line of the package 50. The two holes 35 includes: a first hole extending along a first side and a second side of a polygonal shape being the outer shape of the package 50; and a second hole extending along a third side and a fourth side of the polygonal shape. The first side and the third side oppose to each other, and the second side and the fourth side oppose to each other. In this manner, only two holes 35a are provided on the diagonal line, thereby ensuring the wiring pattern of the bump 53 and preventing the peel off of the bump 53.

Further, if a deformational direction of the printed substrate 30a can be estimated beforehand, the hole 35a may be arranged at a position that is effective for the prevention of the deformation. For example, since the positions in which the printed substrate 30a is fixed within the housing of the main portion 20 by screws are preliminarily recognized, the bending amount of the printed substrate 30a at each position can be estimated. Further, the position of an electrical component generating heat is preliminarily given. Therefore, the hole 35a may be arranged at a position having a maximal value, by estimating the maximal value of the von Mises stress of the four corner portions 55.

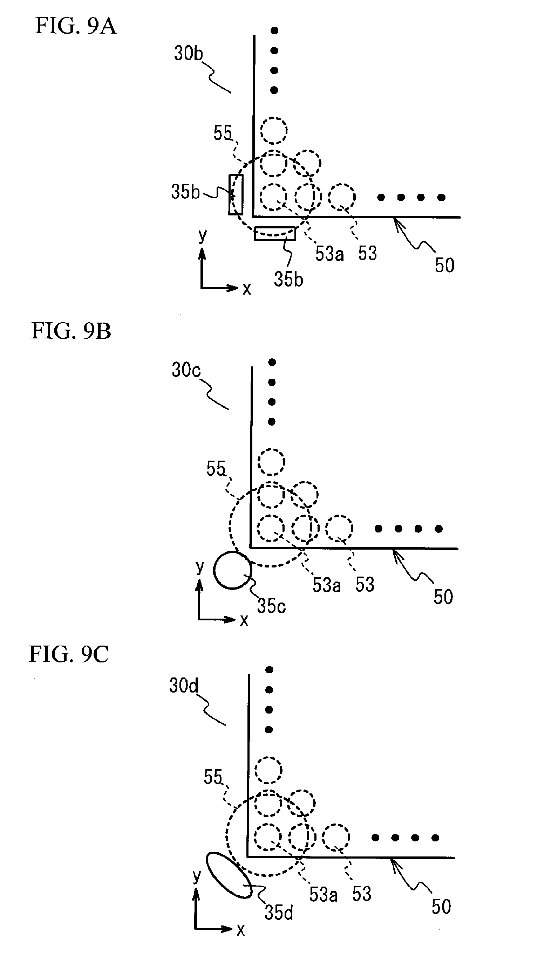

FIG. 9A illustrates a printed substrate 30b according to a second variation. Two holes 35b are provided to correspond to one of the corner portions 55. In other words, the holes 35b are formed such that the hole 35 is divided into two by the diagonal line of the package 50. The holes 35b are provided along respectively two orthogonal adjacent sides. Additionally, each length of the holes 35b is larger than the diameter of the bump 53a. Referring to FIG. 9A, the hole 35b faces the bump 53a.

The holes 35b are divided, so that the wiring pattern is formed between the holes 35b. Especially, the formation of the wiring pattern connecting with the bump 53a is facilitated.

In addition, the holes 35b are divided into two by the diagonal line of the package 50. However the holes are not limited to the configuration, and may be divided into two to face one of the corner portions 55. Thus, the wiring pattern is formed between the holes.

FIG. 9B is a printed substrate 30c according to a third variation. The hole 35c has a circular shape. The diameter of the hole 35c is larger than that of the bump 53a. Therefore, the load applied to the bump 53a can be effectively reduced.

FIG. 9C is a printed substrate 30d according to a fourth variation. The hole 35d has an elliptical shape. The length of the major axis of the hole 35d is larger than the diameter of the bump 53a. Therefore, the load applied to bump 53a can be effectively reduced. Additionally, the angle between the major axis of the hole 35d and one side of the package 50 is 45 degrees.

The holes 35a to 35d according to the variations mentioned above are formed by routing.

The shape of the hole is not limited to the above described shapes. In the above embodiments, the notebook computer is described as an example of the electrical device. However, the electrical device is not limited to this, and may be a desktop computer. Further, the electrical device may be a mobile phone and a portable device such as a portable external hard disk drive. The present invention is not limited to the BGA package, and the CSP (Chip Size Package) including a package having a size substantially identical with a semiconductor chip may be employed.

All examples and conditional language recited herein are intended for pedagogical purposes to aid the reader in understanding the invention and the concepts contributed by the inventor to furthering the art, and are to be constructed as being without limitation to such specifically recited examples and conditions, nor does the organization of such examples in the specification relate to a showing of the superiority and inferiority of the invention. Although the embodiment of the present inventions has been described in detail, it should be understood that various changes, substitutions, and alterations could be made hereto without departing from the scope of the claims.

## Claims

1. A printed substrate comprising:
a plurality of pads provided in a mounting area, and having a polygonal shape, in which an electronic component is mounted; and
a hole facing and extending along at least two adjacent sides of the polygonal shape.

2. The printed substrate of claim 1 wherein the hole at least comprises:
a first hole extending along a first side and a second side of the polygonal shape; and
a second hole extending along a third side and a fourth side of the polygonal shape and being apart from the first hole.

3. The printed substrate of claim 2 wherein the first side and the third side are opposite each other in the polygonal shape, and the second side of the fourth side are opposite each other in the polygonal shape.

4. The printed substrate of claim 2 wherein the hole comprises:
a third hole extending along the first side and the fourth side of the polygonal shape and being apart from the first hole and the second hole; and
a fourth hole extending along the second side and the third side of the polygonal shape and being apart from the second hole and the fourth hole.

5. The printed substrate of claim 1 wherein:
the electronic component comprising a plurality of solder bumps connecting with the plurality of the pads and being mounted in the printed substrate; and
the hole faces an edge of the electronic component.

6. The printed substrate of claim 5 wherein at least one of the solder bumps is made of a lead-free solder.

7. An electronic device comprising:
a printed substrate comprising:
a plurality of pads provided within a mounting area, having a polygonal shape, in which an electronic component is mounted; and
a hole facing and extending along at least two adjacent sides of the polygonal shape; and
a housing housing the printed substrate.

8. A printed substrate comprising:
a plurality of pads provided in a mounting area, having a polygonal shape, in which an electronic component is mounted; and
a hole facing a corner portion of the mounting area.

9. The printed substrate of claim 8 wherein:
the electronic component comprising a plurality of solder bumps connecting with the plurality of the pads and being mounted in the printed substrate; and
the hole facing a corner portion of the electronic component.

10. An electronic device comprising:
a printed substrate comprising:
a plurality of pads provided within a mounting area, having a polygonal shape, in which an electronic component is mounted; and
a hole facing a corner portion of the mounting area; and
a housing housing the printed substrate.

## Amended claims

### Amended claims in accordance with Rule 137(2) EPC.

**1.** A printed substrate (30b) comprising:
a plurality of pads (32) provided in a mounting area (30), having a polygonal shape, in which an electronic component (50) is mounted; and
a hole (35b) facing a corner portion (55) of the mounting area (30), **characterised in that**
the hole (35b) has a shape such that the hole is divided into two discrete portions by a diagonal line of the polygonal shape, wherein the two discrete portions of the hole (35b) are provided on orthogonal adjacent sides of the polygonal shape.

**2.** The printed substrate (30b) of claim 1 wherein:
the electronic component (50) comprises a plurality of solder bumps (53) connecting with the plurality of the pads (32) and being mounted in the printed substrate (30b); and
the hole (35b) facing a corner portion (55) of the electronic component (50).

**3.** The printed substrate (31b) of claim 1 wherein the hole (35b) at least comprises:
a first hole extending along a first side and a second side of the polygonal shape; and
a second hole extending along a third side and a fourth side of the polygonal shape and being apart from the first hole.

**4.** The printed substrate (31b) of 3 wherein the first side and the third side are opposite each other in the polygonal shape, and the second side of the fourth side are opposite each other in the polygonal shape.

**5.** The printed substrate (31b) of claim 3 wherein the hole (35b) comprises:
a third hole extending along the first side and the fourth side of the polygonal shape and being apart from the first hole and the second hole; and
a fourth hole extending along the second side and the third side of the polygonal shape and being apart from the second hole and the fourth hole.

**6.** The printed substrate (31b) of claim 2 wherein at least one of the solder bumps (53) is made of a lead-free solder.

**7.** An electronic device (1) comprising:
the printed substrate (31b) of any preceding claim; and
a housing (20) for housing the printed substrate.
